# EUROPEAN PATENT APPLICATION

(11) **EP 2 768 139 A1**
(43) Date of publication of application: **20.08.2014**
(21) Application number: 14154434.6
(22) Date of filing: 10.02.2014
(51) Int. Cl.: H03K 17/082

(54) **Control system for semiconductor switches**

(30) Priority: 14.02.2013 FI 20135135
(71) Applicant: ABB Oy, 00380 Helsinki (FI)
(72) Inventor: Talja, Markku, 00380 Helsinki (FI); Kankkunen, Jari, 00380 Helsinki (FI)
(74) Representative: Kolster Oy Ab

(57) **Abstract**

A control system for semiconductor switches, the control system (CTRL) being arranged to calculate an estimate of the instantaneous dissipation power of at least one semiconductor component unit (SU1) during an analysis period, whereby the at least one semiconductor component unit (SU1) comprises at least one semiconductor switch (S1), and the instantaneous dissipation power comprises the conduction losses and switching losses of the at least one semiconductor component unit (SU1).

## Description

### Background of the invention

The invention relates to a control system for semiconductor switches.

It is known to protect semiconductor switches against overheating by using protection based on a thermal model, calculated over a time domain of approximately 0.5 ms. In a known semiconductor switch configuration, the temperature rise of a semiconductor component unit is calculated on the basis of a thermal model by taking into account the temperature time constant of the semiconductor component unit, and by using a temperature sensor placed adjacent the semiconductor component unit.

The problem with the protection based on a thermal model is that it does not detect the large switching frequency burst that high current creates.

### Brief description of the invention

It is an object of the invention to develop a control system by means of which the aforementioned problems can be solved. The object of the invention is achieved by a control system which is characterized by what is disclosed in the independent claim. Preferred embodiments of the invention are disclosed in the dependent claims.

The invention is based on arranging the control system to calculate an estimate of the instantaneous dissipation power of a semiconductor component unit during an analysis period, the instantaneous dissipation power comprising the conduction losses and switching losses of the semiconductor component unit. At its shortest, the analysis period has the duration of one switching period of the semiconductor component unit, including the switching on and switching off of a semiconductor switch in the semiconductor component unit.

The control system according to the invention allows fast thermal protection of semiconductor component units.

### Brief description of the figures

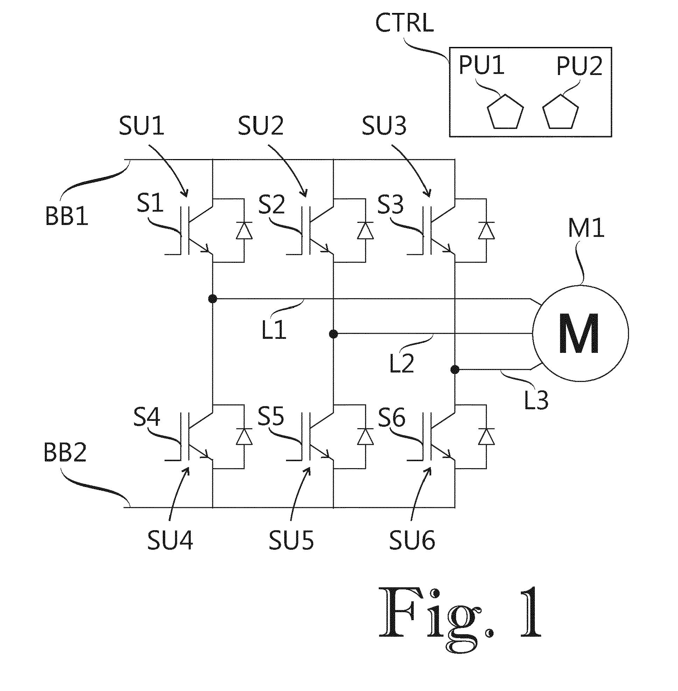

The invention is now described in greater detail in connection with the preferred embodiments and with reference to the attached Figure 1, which shows a semiconductor switch configuration comprising a control system according to an embodiment of the invention.

### Detailed description of the invention

The semiconductor switch configuration of Figure 1 comprises six semiconductor component units SU1 - SU6 and a control system CTRL. Each of the semiconductor component units SU1 - SU6 comprises a controllable semiconductor switch.

The semiconductor switches are series connected in pairs between a first input bus bar BB1 and a second input bus bar BB2, and arranged to invert the direct voltage between the first input bus bar BB1 and second input bus bar BB2 into three-phase alternating voltage which is applied to a motor M1 via output phases L1, L2, and L3. The output phase L1 is connected between the semiconductor switch S1 in the semiconductor component unit SU1 and the semiconductor switch S4 in the semiconductor component unit SU4. The output phase L2 is connected between the semiconductor switch S2 in the semiconductor component unit SU2 and the semiconductor switch S5 in the semiconductor component unit SU5. The output phase L3 is connected between the semiconductor switch S3 in the semiconductor component unit SU3 and the semiconductor switch S6 in the semiconductor component unit SU6.

The control system CTRL is arranged to control the semiconductor switches S1 - S6 in the semiconductor component units SU1-SU6. In addition, the control system CTRL is arranged to calculate an estimate of an instantaneous dissipation power of each semiconductor component unit SU1 - SU6 during an analysis period, the instantaneous dissipation power comprising the conduction losses and switching losses. The minimum duration of the analysis period is one switching cycle, which begins at the switching on and ends at a subsequent switching off. In this context, instantaneous dissipation power refers to the average dissipation power over the analysis period. The control system CTRL uses this instantaneous dissipation power for fast protection of the semiconductor configuration, in other words, in a protection method where the analysis period is substantially shorter than in thermal model based protection.

The control system CTRL includes a real-time dissipation power calculator, where an instantaneous dissipation power of an analysis period is calculated by summing the instantaneous conduction loss power of the analysis period with the instantaneous switching loss power of the analysis period. The calculation of both the instantaneous conduction loss power and the instantaneous switching loss power utilises information on the instantaneous value of the current, that is, the value of the current during the analysis period.

When one controllable semiconductor switch is examined, which is switched on infinitely fast at the beginning of an analysis period and switched off infinitely fast at the end of the analysis period, the instantaneous conduction loss power for the controllable semiconductor switch in question equals the product of the dropout voltage and instantaneous current. The instantaneous switching loss power of an analysis period is the energy that goes into the switching losses during the analysis period divided by the duration of the analysis period. The energy consumed on switching losses includes switching on energies and switching off energies.

The control system CTRL is arranged to carry out a first protective action as a response to the meeting of a first overload condition, the first overload condition comprising the detection of such a situation where the instantaneous dissipation power of at least one of the semiconductor component units SU1 - SU6 exceeds a first threshold value during the analysis period. The first protective action comprises limiting the switching frequency of the semiconductor switch in each semiconductor component unit where the instantaneous dissipation power exceeds the first threshold value during the analysis period.

The semiconductor component units SU1 - SU6 are identical to one another, so they all have the same first threshold value during the analysis period. In an alternative embodiment, the semiconductor switch configuration may comprise semiconductor component units that differ from one another and which have different first threshold values during the analysis period. The control system can be arranged to one where the semiconductor component unit specific first threshold values can be entered in the control system in connection with the initial settings.

The control system CTRL is additionally arranged to carry out a second protective action as a response to the meeting of a second overload condition, the second overload condition comprising the detection of such a situation where the instantaneous dissipation power of at least one of the semiconductor component units SU1 - SU6 exceeds the first threshold value during the analysis period despite the use of the first protective action. The second protective action comprises limiting the current of the semiconductor switch in each semiconductor component unit where the instantaneous dissipation power exceeds the first threshold value during the analysis period despite the first protective action being applied to the semiconductor component unit in question.

Furthermore, the control system CTRL is arranged to carry out a third protective action as a response to the meeting of a third overload condition, the third overload condition comprising the detection of such a situation where the instantaneous dissipation power of at least one of the semiconductor component units SU1 - SU6 exceeds the first threshold value during the analysis period despite the use of the second protective action. The third protective action comprises the keeping of the semiconductor switch in non-conducting state in each semiconductor unit where the instantaneous dissipation power exceeds the first threshold value during the analysis period despite the use of the second protection method. The keeping of the semiconductor switch in the non-conducting state is continued until the predefined continuation conditions are met.

The control system CTRL comprises a first processor unit PU1, which is arranged to control the semiconductor switch in each semiconductor component unit, and a second processor unit PU2, which is arranged to calculate an estimate for the instantaneous dissipation power of each semiconductor component unit during an analysis period. In such a case, the calculation of the dissipation power does not load the first processor unit PU1, in charge of controlling the semiconductor switches S1 - S6 in the semiconductor component units SU1 - SU6.

The second processor unit PU2 has available to it the details of the changes in state and instantaneous currents of the semiconductor switches S1 - S6 in the semiconductor component units SU1- SU6. The control system CTRL is arranged to one where the semiconductor component unit specific switching on and switching off energies can be entered to the second processor unit PU2 in connection with the initial settings. The dropout voltage curves of the semiconductor switches S1 - S6 are tabulated on the second processor unit PU2. The second processor unit may comprise, for example, an FPGA integrated circuit or an ASIC integrated circuit.

The control system according to the invention may be arranged to calculate an estimate of the instantaneous dissipation power of one or more semiconductor component units during an analysis period. A semiconductor component unit may comprise one or more semiconductor switches.

In the embodiment shown in Figure 1, each of the semiconductor component units SU1 - SU6 comprises an IGBT type of transistor, in which the actual semiconductor switch is connected antiparallel to the diode. The actual semiconductor switches are marked with reference marks S1 - S6 whereas no reference marks are used to mark the diodes. In alternative embodiments, the semiconductor switch configuration according to the invention may comprise other types of semiconductor switches, too.

The control system according to the invention may be arranged to utilise the calculation of instantaneous dissipation power for fast protection, and to utilise the prior art calculation, which is based on a thermal model, for longer-term protection.

It is apparent to a person skilled in the art that the basic idea of the invention may be implemented in many different ways. The invention and its embodiments are thus not restricted to the examples described above but may vary within the scope of the claims.

## Claims

1. A control system for semiconductor switches, **characterised in that** the control system (CTRL) is arranged to calculate an estimate of the instantaneous dissipation power of at least one semiconductor component unit (SU1) during an analysis period, the at least one semiconductor component unit (SU1) comprising at least one semiconductor switch (S1), the instantaneous dissipation power comprising the conduction losses and switching losses of the at least one semiconductor component unit (SU1).

2. A control system according to claim 1,**characterised in that** the control system (CTRL) comprises a first processor unit (PU1), which is arranged to control the switching on and switching off of the at least one semiconductor switch (S1) in the at least one semiconductor component unit (SU1), and a second processor unit (PU2), which is arranged to calculate an estimate for the instantaneous dissipation power of the at least one semiconductor component unit (SU1) during an analysis period.

3. A control system according to claim 1 or 2, **characterised in that** the control system (CTRL) is arranged to carry out a first protective action as a response to the meeting of a first overload condition, the first overload condition comprising the detection of such a situation where the instantaneous dissipation power of an analysis period for the at least one semiconductor component unit (SU1) exceeds a first threshold value.

4. A control system according to claim 3, **characterised in that** the first protective action comprises the limiting of the switching frequency of the at least one semiconductor switch (S1) in the at least one semiconductor component unit (SU1) whose instantaneous dissipation power of an analysis period exceeds the first threshold value.

5. A control system as claimed in claim 3 or 4, **characterised in that** the control system (CTRL) is arranged to carry out a second protective action as a response to the meeting of a second overload condition, the second protective action comprising limiting the current of the at least one semiconductor switch (S1) in the at least one semiconductor component unit (SU1).

6. A control system according to claim 5, **characterised in that** the second overload condition comprises the detection of such a situation where the instantaneous dissipation power of an analysis period for the at least one semiconductor component unit (SU1) exceeds the first threshold value despite the use of the first protective action.

7. A control system as claimed in claim 5 or 6, **characterised in that** the control system (CTRL) is arranged to carry out a third protective action as a response to the meeting of a third overload condition, the third protective action comprising the keeping of the at least one semiconductor switch (S1) in the at least one semiconductor component unit (SU1) in non-conducting state until predefined continuation terms are met.

8. A control system according to claim 7, **characterised in that** the third overload condition comprises the detection of such a situation where the instantaneous dissipation power of an analysis period for the at least one semiconductor component unit (SU1) exceeds the first threshold value despite the use of the second protective action.

9. A control system according to any of the preceding claims, **characterised in that** the analysis period is of the duration of the switching period of the semiconductor component unit (SU1), including a switching on and a switching off of the at last one semiconductor switch (S1).

10. A semiconductor switch configuration that comprises at least one semiconductor component unit (SU1) and control system, the at least one semiconductor component unit (SU1) comprising at least one semiconductor switch (S1), the control system being arranged to control the at least one semiconductor switch (S1) in the at least one semiconductor component unit (SU1), **characterised in that** the control system is the control system (CTRL) as claimed in any one of claims 1 - 9.
